(19) Europäisches Patentamt / European Patent Office / Office européen des brevets

(11) **EP 1 892 723 B1**

(12) **FASCICULE DE BREVET EUROPEEN**

(45) Date de publication et mention
de la délivrance du brevet:
**29.02.2012 Bulletin 2012/09**

(51) Int Cl.:
**G11C 13/02** *(2006.01)*

(21) Numéro de dépôt: **07114601.3**

(22) Date de dépôt: **20.08.2007**

(54) **Dispositif de mémoire électrochimique**

Elektrochemische Speichervorrichtung

Electrochemical memory device

(84) Etats contractants désignés:
**DE FR GB IT**

(30) Priorité: **21.08.2006 FR 0653411**

(43) Date de publication de la demande:
**27.02.2008 Bulletin 2008/09**

(73) Titulaire: **Commissariat à l'Énergie Atomique et aux Énergies Alternatives**
**75015 Paris (FR)**

(72) Inventeurs:
• **Bloch, Didier**
**38330 BIVIERS (FR)**
• **Le Cras, Frédéric**
**38470 Notre-Dame-de-l'Osier (FR)**

(74) Mandataire: **Poulin, Gérard et al**
**BREVALEX**
**95, rue d'Amsterdam**
**75378 Paris Cedex 8 (FR)**

(56) Documents cités:
| EP-A- 1 571 673 | EP-A- 1 657 760 |
| EP-A2- 0 380 058 | DE-A1-102004 046 392 |
| FR-A- 2 873 856 | US-A- 5 601 952 |

**Description**

**DOMAINE TECHNIQUE**

L'invention est relative au domaine des mémoires et concerne une nouvelle technologie de mémoires que l'on nommera « NEMO's » dans la suite de ce document pour « Nano Electrochemical MemOries ». La présente invention prévoit la réalisation d'une cellule mémoire électronique électrochimique formée d'un empilement de couches minces comprenant au moins une première couche active, apte à libérer et/ou accepter de manière réversible au moins une espèce ionique, au moins une deuxième couche active, apte à libérer et/ou accepter de manière réversible ladite espèce ionique, un électrolyte solide entre la première couche active et la deuxième couche active. Des moyens générateurs d'impulsions de courant pour modifier l'état de la cellule ainsi qu'une mesure de la différence de potentiel électrochimique entre la première couche active et la deuxième couche active afin de déterminer l'état de la cellule sont prévus.

L'invention peut être intégrée en particulier dans de nombreux dispositifs électroniques, informatiques, terminaux de communications, appareils, équipements.

**ART ANTÉRIEUR**

Une structure de cellule mémoire appelée « PMC » (PMC pour « *Programmable Metallization Cell* » selon la terminologie anglo-saxonne) formée d'un électrolyte solide situé entre deux électrodes est présentée dans le document US 5 761 115.

Le fonctionnement des cellules mémoires PMC est basé sur la formation au sein de l'électrolyte solide, d'éléments métalliques appelés « dendrites » entre deux électrodes, lorsque ces électrodes sont portées à des potentiels respectifs appropriés. La formation des dendrites permet d'obtenir une conduction électrique donnée entre les deux électrodes dès qu'un pont conducteur dendritique est établi entre les deux électrodes. En modifiant les potentiels respectifs appliqués aux électrodes, il est possible de modifier la répartition et le nombre de ponts conducteurs dendritiques établis, et de modifier ainsi la conduction électrique entre les deux électrodes. En inversant par exemple le potentiel entre les électrodes, il est possible, par dissolution partielle des ponts conducteurs dendritiques, de rompre le contact établi par ces ponts entre les électrodes et donc de supprimer, ou au moins de réduire considérablement, la conduction électrique.

Les cellules PMC peuvent ainsi avoir un fonctionnement à deux états : un état dit « ON » et un état dit « OFF » et jouer le rôle de cellules mémoires. Dans les cellules mémoires PMC, l'électrolyte solide peut être à base d'un chalcogénure tel que du GeSe, conducteur des ions argent. Cet électrolyte est conducteur ionique et isolant électronique, et placé généralement entre une électrode à base d'argent, et une électrode inerte, par exemple à base de Nickel. A l'état initial, aucun contact n'est établi entre les deux électrodes qui sont séparées par un isolant. Lorsqu'une tension de polarisation est appliquée entre les deux électrodes, l'électrode d'argent fournit des ions $Ag^+$ qui traversent l'électrolyte et se déposent sur l'électrode opposée en constituant une ou plusieurs dendrites d'argent métallique. Lorsqu'une ou plusieurs dendrites parviennent à franchir l'électrolyte dans toute son épaisseur, et à venir en contact avec l'électrode d'argent qui leur fait face, un pont conducteur est établi, et la mémoire passe à l'état « conducteur ». Une cellule mémoire PMC est susceptible de passer très rapidement de l'état « conducteur » à l'état « isolant ». Ces deux états correspondent aux actions « écriture » et « effacement » de la mémoire.

Les mémoires PMC présentent cependant plusieurs inconvénients. Au bout d'un certain nombre de cycles d'écriture/effacement, les dendrites à base d'argent sont simultanément présentes sur les deux électrodes en regard l'une de l'autre. Un système Electrode d'argent/électrolyte/Electrode d'argent symétrique est susceptible de se former. Quel que soit le signe, positif ou négatif, de la tension imposée, le risque de créer un chemin de dendrites conductrices entre les deux électrodes est alors important, ce qui va à l'encontre de l'objectif recherché. Le maintien de la tension d'effacement, qui devrait conduire à la rupture de la dendrite formée sur l'une des deux électrodes, va en fait conduire au contraire à la formation d'une dendrite (sur l'électrode opposée à la première) qui mettra les deux électrodes à nouveau en court-circuit.

En outre, la croissance des dendrites d'argent ne s'effectue pas de manière contrôlée. En effet, au bout d'un certain nombre de cycles effacement/écriture, le milieu électrolytique entre les deux électrodes est gorgé d'agrégats métalliques isolés, et il devient impossible de maîtriser le fonctionnement du système : les ponts conducteurs s'établissent ou se dissolvent de manière aléatoire lors des étapes d'écriture et d'effacement, et la fiabilité du dispositif est diminuée.

Un autre type de mémoire a été proposé, par exemple dans le document US 6 864 522, qui divulgue une mémoire électrochimique comprenant : deux électrodes collectrices de courant, et un empilement de couches comprenant au moins une couche active dont on fait varier la conductivité électrique en appliquant une différence de potentiel entre les deux électrodes.

Il se pose le problème de trouver un nouveau dispositif de cellule mémoire électrochimique ne comportant pas les inconvénients mentionnés ci-dessus, et plus sensible que les mémoires électrochimiques basées sur la variation de conductivité des électrodes.

Le document EP 1571673 concerne un dispositif de mémoire, comprenant un ensemble de cellules de mémoire, chaque cellule comportant un élément de mémoire pouvant stocker une pluralité de données en changeant une valeur de résistance dans au moins deux états de résistance élevée et de faible résistance et d'un transistor servant à commander l'accès à l'élément de mémoire est agencée dans une pluralité de colonnes et dans une pluralité de rangées, l'élément de mémoire comprenant : une première électrode ; une seconde électrode agencée à l'opposé de la première électrode; et une couche de matériau inter-électrode permettant la conduction d'électrons ou d'ions, qui est située entre la première électrode et la seconde électrode et contient un matériau actif de réaction d'oxydoréduction, dans lequel, lorsqu'une tension supérieure a une valeur seuil est appliquée à la première électrode et à la seconde électrode, les caractéristiques électriques entre la première électrode et la seconde électrode changent et les informations sont de ce fait enregistrées ;

un moyen de commande servant a commander l'accès à la cellule de mémoire, qui comporte un décodeur d'adresse de rangée connecté à une pluralité de cellules de mémoire dans l'ensemble de cellules de mémoire par le biais d'une ligne de mots et un décodeur d'adresse de colonne connecté à la pluralité de cellules de mémoire par le biais d'une ligne de bits ;

Un moyen d'alimentation servant à appliquer une tension de lecture donnée à la cellule de mémoire, qui comprend des première et seconde lignes d'alimentation ; un amplificateur de détection servant a détecter les données stockées dans la cellule de mémoire ; et un circuit de charge servant à convertir un courant circulant jusqu'à la ligne de bits à travers la cellule de mémoire lors de la lecture en une tension, dans lequel lorsque la valeur de résistance de l'élément de mémoire est dans un état de résistance élevée s'exprime par R_mem_high ; la valeur de résistance de l'élément de mémoire est dans un état de faible résistance s'exprime par R_mem_low1 ; la valeur de résistance du circuit de charge s'exprime par R_load ; la tension de lecture appliquée entre la première ligne d'alimentation et la seconde ligne d'alimentation pour lecture en fixant la tension de la seconde ligne d'alimentation à une tension de référence s'exprime par Vread ; et la tension seuil à laquelle le changement de la valeur de résistance de l'élément de mémoire est généré s'exprime par Vth_critical, l'état de faible résistance est créé de sorte que les relations des formules (1) et (2) suivantes soient satisfaites lors de l'écriture de données dans la cellule de mémoire.

$$\text{Formule (1)}$$
$$\texttt{R\_mem\_low1<=\{Vread*R\_mem\_high/(R\_mem\_high+R\_load)-}$$
$$\texttt{0,01\}*R\_load/\{Vread*R\_mem\_high/(R\_mem\_high+R\_load)}$$
$$\texttt{*R\_load/R\_mem\_high+0,01}$$

$$\text{Formule (2)}$$
$$\texttt{Vread*R\_mem\_high/(R\_mem\_high+R\_load)< =Vth\_critical.}$$

Le document EP 380058 concerne une cellule électrochimique à l'état solide comprenant au moins une paire d'électrodes et une couche d'électrolyte solide conductrice des ions argent qui est disposée entre les électrodes, dans laquelle au moins l'une desdites électrodes contient comme matière active d'électrode un oxyde de composé constitué d'oxyde d'argent et d'un oxyde des métaux de transition, et dans laquelle ladite couche d'électrolyte solide conductrice des ions argent est constituée de $aAgXbAg_2O\text{-}cM_kO_1$, où x est choisi dans le groupe constitué de I, Br et Cl ; M est choisi dans le groupe constitué de W, Mo, Si, V, Cr, P et B ; et les relations

$$0,1 \leq a/(a + b + c) \leq 1,0$$

et

$$2/7 \leq k/1 \leq 2/3$$

sont satisfaites, ou dans laquelle ladite couche d'électrolyte solide conductrice des ions argent est composée de pAgX-

$qAgM_mO_n$, où X et M sont tels que définis ci-dessus, et les relations

$$0,1 \leq p/(p + q) \leq 1,0$$

et

$$1,5 \leq m/n \leq 2/3$$

sont satisfaites.

## EXPOSÉ DE L'INVENTION

L'invention concerne un dispositif de mémoire comprenant un empilement de couches comportant :

- au moins une première couche active à base d'un matériau cristallin conducteur ionique et électronique, apte à libérer et/ou accepter au moins une espèce ionique,
- au moins une deuxième couche active à base d'un matériau cristallin conducteur ionique et électronique, apte à libérer et/ou accepter ladite espèce ionique,
- au moins une couche formant un électrolyte entre la première couche active et la deuxième couche active, et à base d'au moins un matériau conducteur ionique et isolant électronique,
- des moyens de mesure de la différence de potentiel électrochimique entre ladite première couche et de ladite deuxième couche.

La première couche active et la deuxième couche active sont à base de $LiMn_2O_4$ et présentent une forte variation de potentiel, supérieure ou égale à 0,3 volts ou à 0,5 volts pour une faible variation en concentration de ladite espèce ionique, inférieure à 5 % ou à 10 % autour d'une composition donnée particulière du matériau.

Un dispositif suivant l'invention met en oeuvre une mesure de différence de potentiel électrochimique plus sensible qu'un système suivant l'art antérieur basé sur des variations de conductivité électrique de l'électrode.

L'invention met en oeuvre une mesure de variation(s) de potentiel électrochimique des matériaux des couches actives sous l'effet d'une faible variation de leurs compositions respectives.

Le dispositif de mémoire selon l'invention peut comprendre en outre des moyens générateurs de courant aptes à injecter du courant dans ledit empilement sous forme d'impulsions de courant.

Ce dispositif peut également être soumis à des variations de potentiel importantes à ses bornes, sans que la variation de conductivité des électrodes soit importante. L'invention met en oeuvre un dispositif doté de couches actives dans lesquelles la variation d'impédance est faible ou nulle. En particulier, la première couche active et/ou la deuxième couche active peuvent avoir une faible variation de conductivité électrique suite à une émission d'une impulsion de courant en provenance des moyens générateurs.

Selon une possibilité, le dispositif peut comprendre en outre : au moins une couche métallique de collecteur en contact avec la première couche active et au moins une autre couche métallique de collecteur en contact avec la deuxième couche active.

Le matériau des couches « actives » est un matériau choisi de sorte qu'une faible variation de concentration en espèces chargées des couches actives provoque autour d'une composition donnée particulière du matériau, une variation importante de son potentiel électrochimique. Ainsi, selon l'invention et contrairement à l'art antérieur, la variation de potentiel est générée bien que la conductivité électrique entre les couches varie très peu.

La première couche active et/ou la deuxième couche active peuvent être à base d'un composé d'intercalation comportant au moins un oxyde de métal de transition.

Selon une possibilité, la première couche active et la deuxième couche active peuvent être identiques.

La première couche active et la deuxième couche active peuvent être à base de $LiMn_2O_4$, qui présente avantageusement une variation de potentiel électrochimique importante pour une faible variation en espèce chargée $Li^+$ au sein du matériau autour de la composition $LiMn_2O_4$.

L'invention concerne un dispositif de mémoire tel que défini plus haut.

Le dispositif de mémoire suivant l'invention présente une consommation améliorée, et fonctionne sous des tensions faibles. Les processus d'écriture et d'effacement du dispositif de mémoire suivant l'invention sont rapides, réversibles, reproductibles, et fiables dans le temps.

L'invention concerne au moins un procédé de commande d'un dispositif de mémoire comprenant un empilement de couches comportant :

- au moins une première couche active à base d'un matériau cristallin conducteur ionique et électronique, apte à libérer et/ou accepter au moins une espèce ionique,
- au moins une deuxième couche active à base d'un matériau, cristallin conducteur ionique et électronique, apte à libérer et/ou accepter ladite espèce ionique,
- au moins une couche formant un électrolyte entre la première couche active et la deuxième couche active, et à base d'au moins un matériau conducteur ionique et isolant électronique, le procédé comprenant au moins une étape de mesure de la différence de potentiel électrochimique entre ladite première couche active et de ladite deuxième couche active.

Selon une possibilité de mise en oeuvre, le procédé peut comprendre au moins une étape d'injection d'au moins une impulsion de courant dans ledit empilement.

La première couche active et la deuxième couche active étant à base de $LiMn_2O_4$ et présentent une forte variation de potentiel, pour une faible variation en concentration de ladite espèce ionique, un dispositif suivant l'invention ne nécessite pas des électrodes d'épaisseur importante, de sorte que les électrodes de la mémoire peuvent avoir une épaisseur inférieure à 1 $\mu$m.

## BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :

- la figure 1 illustre un dispositif de mémoire suivant l'invention,
- la figure 2 illustre une courbe de potentiel d'électrode d'un système « lithium métallique/électrolyte/électrode contenant $LiMn_2O_4$ », permettant de comprendre le fonctionnement d'un dispositif de mémoire suivant l'invention, en fonction de la concentration en espèce chargée des électrodes.

Les différentes parties représentées sur les figures ne le sont pas nécessairement selon une échelle uniforme, pour rendre les figures plus lisibles.

## EXPOSÉ DÉTAILLÉ DE MODES DE RÉALISATION PARTICULIERS

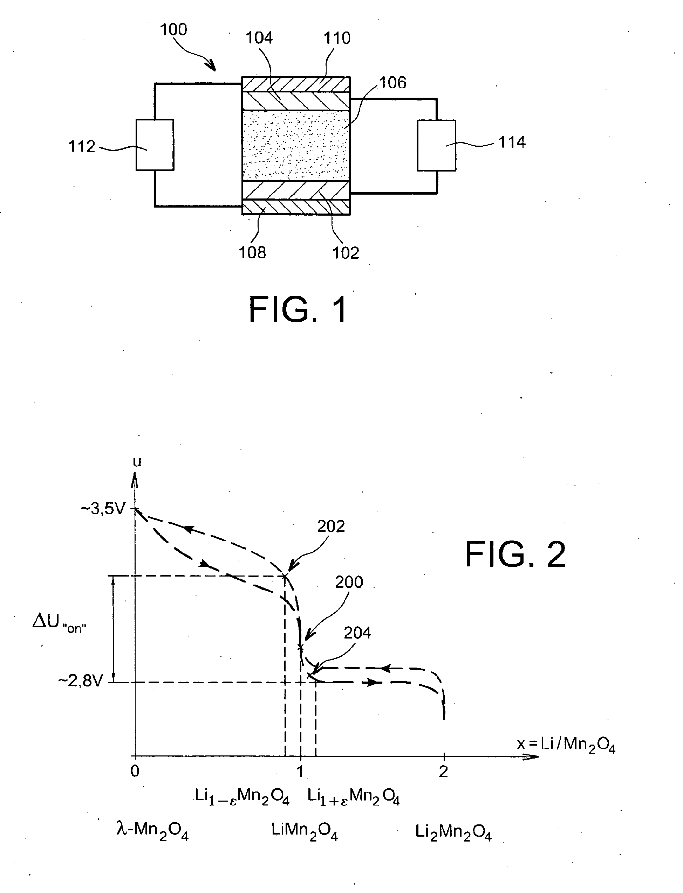

Un exemple de dispositif de cellule mémoire électrochimique selon l'invention est illustré sur la figure 1. Ce dispositif 100 comprend un empilement de couches minces comportant une première couche 102 dite « active » à base d'un matériau cristallin conducteur ionique et électronique, apte à contenir au moins une espèce ionique et d'autre part à libérer et/ou accepter cette espèce ionique. La première couche 102 active peut être à base d'au moins un composé d'intercalation comportant un oxyde de métal de transition. Le composé d'intercalation peut être un oxyde de métal de transition lithié par exemple un oxyde de manganèse lithié $Li_xMn_yO_z$ (avec x, y, z des nombres entiers) tel que du $LiMn_2O_4$, ayant une structure spinelle stoechiométrique. La première couche 102 peut avoir une épaisseur comprise par exemple entre 10 nanomètres et 200 nanomètres ou au moins inférieure à 1000 nm.
L'empilement de couches minces comporte également une deuxième couche 104 dite « active », à base d'un matériau cristallin conducteur ionique et électronique, apte à contenir au moins une espèce ionique et d'autre part à libérer et/ou accepter cette espèce ionique. La deuxième couche 104 active peut être à base d'au moins un composé d'intercalation comportant un oxyde de métal de transition tel qu'un oxyde de métal de transition lithié par exemple un oxyde de manganèse lithié $Li_xMn_yO_z$ tel que du $LiMn_2O_4$, ayant une structure spinelle stoechiométrique. La deuxième couche 104 active peut avoir une épaisseur comprise par exemple entre 10 nanomètres et 200 nanomètres ou au moins inférieure à 1000 nm. Selon une possibilité de mise en oeuvre, les couches actives 102 et 104 peuvent être identiques.
Une couche ou un empilement de couches formant un électrolyte 106 sépare la première couche 102 active de la deuxième couche 104 active. L'électrolyte 106 peut être formé par exemple d'un matériau conducteur ionique et isolant électronique, par exemple un verre de type « Lipon® » ou de composition : $1B_2O_3$-$0,8Li_2O$-$0,8Li_2SO_4$. L'épaisseur de l'électrolyte 106 est choisie de manière à être étanche au passage des électrons, mais suffisamment faible pour ne pas opposer de résistance trop importante au passage des ions. L'épaisseur de la couche 106 d'électrolyte peut être par exemple comprise entre 10 nanomètres et 200 nanomètres ou peut être par exemple de l'ordre de 100 nanomètres. Deux couches de collecteur de courant 108, 110 peuvent être associées à chacune des couches actives 102, 104.
Le dispositif comprend également des moyens 112 générateurs de courant, aptes à émettre des impulsions de courant vers la première couche active 102 et/ou vers la deuxième couche active 104, pour permettre un échange

**EP 1 892 723 B1**

d'espèce ionique entre les couches actives 102 et 104 et un basculement de la cellule mémoire d'un état donné vers un autre donné. Des moyens peuvent être prévus pour mesurer la quantité totale de courant (par exemple en μAh) fournie par ou au dispositif 100.

La cellule mémoire est susceptible d'adopter au moins deux états distincts dont un état dit état « ON » pour lequel la première couche active 102 et la deuxième couche active 104 ont des compositions en espère ionique respectives données, et un autre état « OFF » pour lequel la première couche active 102 et la deuxième couche active 104 ont des compositions respectives en espèce ionique différentes desdites compositions données. Dans le cas par exemple où les couches actives 102, 104 sont à base d'un oxyde de métal de transition lithié, une variation de concentration en ions lithium de l'ordre de 10 % dans les couches actives 102 et 104 peut permettre de traduire le basculement d'un premier état « ON » ou « OFF » à un deuxième état, « OFF » ou « ON », de la cellule mémoire.

Les impulsions de courant émises par les moyens 112 générateurs de courant peuvent être des impulsions d'intensité faible comprise par exemple entre $10^{-9}$ A et $10^{-6}$ A pendant une durée par exemple comprise entre 1 ns et 1 s. Une impulsion d'intensité de l'ordre de $10^{-7}$ A pendant une durée de l'ordre d'une seconde peut être émise par exemple pour faire basculer la cellule mémoire d'un état « ON » à un état « OFF » ou inversement.

Les moyens 112 générateurs de courant, peuvent être prévus pour émettre une impulsion de courant d'intensité donnée vers la première couche active 102 pour faire basculer la cellule d'un premier état « ON » ou « OFF » à un deuxième état « OFF » ou « ON » et également une impulsion de courant opposée, vers la deuxième couche active 104, d'intensité égale à l'intensité donnée pour faire basculer la cellule du deuxième état « OFF » ou « ON » au premier état « ON » ou « OFF ». Alternativement, pour faire basculer le système de l'état « ON » à l'état « OFF », on peut mettre le système en court-circuit : les deux électrodes étant de compositions différentes avec un fort potentiel entre elles, les compositions vont s'équilibrer automatiquement en délivrant un courant dans le circuit extérieur pour revenir à l'état initial $LiMn_2O_4$/électrolyte/$LiMn_2O_4$ dans le cas illustré, système dont le potentiel aux bornes est nul.

Le dispositif comprend également des moyens 114 de mesure connectés à la première couche active 102 et à la deuxième couche active 104, aptes à mesurer une différence de potentiel électrochimique entre ladite première couche active 102 et ladite deuxième couche active 104. Cette différence de potentiel électro-chimique peut être déterminée par une mesure de différence potentiel entre les couches actives 102 et 104. Les moyens 114 de mesure peuvent permettre de déterminer l'état dans lequel se trouve la cellule mémoire.

Plus généralement, les impulsions de courant émises par les moyens générateurs 112 sont prévues pour avoir une intensité suffisante pour faire basculer la cellule mémoire d'un premier état « OFF » à un deuxième état « ON » ou éventuellement d'un état « ON » à un état « OFF ». L'état « ON » de la mémoire est un état associé à une première valeur de différence de potentiels électrochimiques entre la première couche active 102 et la deuxième couche active 104 ou une première gamme de valeurs de différences de potentiels électrochimiques entre la première couche active 102 et la deuxième couche active 104. L'état « OFF » de la mémoire est un état associé à une deuxième valeur de différence de potentiels électrochimiques entre la première couche active 102 et la deuxième couche active 104 ou à une deuxième gamme de valeurs de différences de potentiels électrochimiques entre la première couche active 102 et la deuxième couche active 104. Ladite deuxième valeur est différente de la première valeur ou lesdites valeurs de ladite deuxième gamme sont différentes des valeurs de ladite première gamme.

Selon une possibilité, l'état « OFF » peut être associé à une valeur nulle de différence de potentiel électrochimique entre les deux couches actives 102 et 104. La représentation d'un état « OFF » par une valeur nulle de différence de potentiel électrochimique peut être permise par des couches actives 102 et 104 identiques.

La première couche active 102 et la deuxième couche active 104 sont à base respectivement d'un matériau d'intercalation choisi de sorte que sous l'effet d'une faible variation de composition ou de concentration en espèce chargée au voisinage d'une composition donnée du matériau, ce matériau présente une importante variation de potentiel électrochimique. Une couche à base de $LiMn_2O_4$ présente par exemple une importante variation de potentiel électro-chimique sous l'effet d'une faible variation de composition ou de concentration en ions $Li^+$. Le matériau d'intercalation respectif de la couche active 102 et de la couche active 104 est choisi de sorte que ce matériau présente une variation de potentiel au moins égale ou supérieure à 0,3 volts ou au moins égale ou supérieure à 0,5 volts sous l'effet d'une variation de concentration en espèce chargée inférieure à 10 % ou inférieure à 5 % ; en particulier, pour des électrodes en $LiMn_2O_4$ initialement, on peut ainsi obtenir 0,4 V par exemple. Le fait que le processus d'intercalation et de désintercalation du lithium dans des matériaux tels que $LiMn_2O_4$ au voisinage immédiat de cette composition soient connus pour être réversibles confère à la cellule mémoire une fiabilité améliorée en ce qui concerne la rétention d'information et une cyclabilité accrue.

L'empilement de couches 100 peut également comprendre une couche 108 dite de « collecteur » en contact avec la première couche active 102. La couche 108 dite de « collecteur » est à base d'un matériau conducteur de l'électricité, qui peut être un matériau métallique tel que par exemple du Ni. Une autre couche 110 de « collecteur » en contact avec la deuxième couche active 104 peut être prévue ; l'autre couche 110 de « collecteur » peut être à base d'un matériau conducteur de l'électricité, qui peut être un matériau métallique tel que par exemple du Ni. Les couches 108 et 110 de collecteur peuvent être connectées au moyens générateurs 112 de courant et/ou aux moyens de mesure

**6**

114 qui peuvent mesurer alors une différence de potentiel électrochimique entre ces couches de collecteur 108, 110 ; ces couches 108, 110 peuvent avoir une épaisseur comprise par exemple entre 10 nm et 100 nm. La couche 108 de collecteur et la première couche active 102 forment une première électrode, tandis que la couche 110 de collecteur et la deuxième couche active 104 forment une deuxième électrode.

Un exemple de fonctionnement d'une cellule mémoire dotée de couches actives 102 et 104 à base de $LiMn_2O_4$ va à présent être donné en liaison avec la courbe de la figure 2, sur laquelle, en abscisse figure un rapport atomique $Li/Mn_2O_4$ tandis qu'en ordonnée est donné le potentiel mesuré entre une couche active et une électrode de référence de lithium métallique. A l'état initial (point référencé 200 sur la courbe), les deux couches actives 102 et 104 ont une composition semblable et la différence de potentiel entre les deux couches actives 102 et 104 est nulle. Ce premier état peut être considéré comme un état dit « OFF » de la mémoire.

L'imposition d'une première impulsion de courant par les moyens générateurs 112 vers la couche 108 de collecteur en contact avec la première couche active 102, permet un échange d'une faible quantité d'espèce chargée $Li^+$ entre les deux couches actives 102, 104.

Suite à l'émission de ladite première impulsion de courant, la réaction électrochimique au niveau de la deuxième couche active 104 peut être la suivante :

$$(1) \quad LiMn_2O_4 + \varepsilon\ Li^+ => Li_{1+\varepsilon}Mn_2O_4$$

Au niveau de la première couche active 102, la réaction électrochimique suivante peut avoir lieu :

$$(2) \quad LiMn_2O_4 - \varepsilon\ Li^+ => Li_{1-\varepsilon}Mn_2O_4$$

Suite à l'émission de la première impulsion, le potentiel de la première couche active 102 (portion de courbe 204) formée d'un composé $Li_{1+\varepsilon}Mn_2O_4$ est voisin de 2,85 Volts, tandis que celui de la deuxième couche 104 formée d'un composé $Li_{1-\varepsilon}Mn_2O_4$ s'élève (portion de courbe 202) correspondant à la désintercalation du lithium. Il apparaît qu'une faible variation de concentration en espèce ionique dans les couches 102, 104, induit par un échange d'espèces chargées entre ces dernières, se traduit par une variation importante de potentiel entre les deux couches actives 102, 104. La vitesse à laquelle le potentiel croît est rapide et conditionnée par la vitesse de diffusion des espèces chargées à l'intérieur du système formé par l'électrolyte et les couches actives. La mémoire atteint un état « ON ». Lorsque l'impulsion de courant cesse d'être imposée, le flux d'espèces chargées cesse aussitôt à l'intérieur de l'électrolyte 106 et les couches actives 102, 104 restent en l'état dans lequel elles se trouvent. Les moyens 114 de mesure du potentiel aux bornes du système fournissent l'indication de l'état « ON » de la mémoire. Cet état de la mémoire est maintenu grâce à l'électrolyte 106, qui, de par le matériau qui le compose ainsi que de par son épaisseur, empêche la diffusion spontanée des ions $Li^+$ en l'absence d'impulsions de courants.

L'effacement de cette mémoire peut être réalisée en imposant une deuxième impulsion de courant égale et opposée à la première impulsion de courant précédemment imposée, encore en mettant le système en court-circuit. (Par opposée on entend que la deuxième impulsion de courant d'intensité égale à l'intensité de la première impulsion, émise vers avec la deuxième couche active 104.)

Le système se retrouve alors à l'état « OFF » initial, avec deux couches actives 102 et 104 identiques de part et d'autre de l'électrolyte 106.

Sur la figure 2, on peut observer qu'il existe deux courbes donnant chacune l'évolution de la tension aux bornes du système lithium métallique (électrode négative)/électrolyte/électrode active (positive) en fonction de la quantité de lithium contenu dans le matériau actif d'électrode positive. De fait, ce système est un accumulateur au lithium qui peut être « déchargé » lorsqu'on place une résistance à ces bornes (le système fournit alors spontanément un courant, et la tension à ses bornes décroît progressivement), ou « rechargé » lorsqu'on lui fournit un courant électrique grâce à un générateur externe (la tension aux bornes du système croît alors progressivement). La première courbe correspond entre 3,5 V et 2,5 V à l'intercalation du lithium dans la structure $\lambda$-$Mn_2O_4$ pour former $Li_2Mn_2O_4$ (« décharge » de l'accumulateur) ; la deuxième courbe correspond à l'inverse à la désintercalation entre 2,5 V et 3,5 V du lithium de la structure $Li_2Mn_2O_4$ pour former à nouveau le composé initial $\lambda$-$Mn_2O_4$ (« charge » de l'accumulateur). L'hystérésis observé entre les deux courbes, qui dépend de l'intensité du courant traversant le système (« régime » de charge ou de décharge), traduit les surtensions aux électrodes ainsi que la résistance interne du système. Pour un courant de charge ou de décharge donné, une faible différence de potentiel, typiquement voisine de 100 à 200 mV, entre les deux courbes traduit une faible résistance interne du système tout au long du processus d'intercalation et de désintercalation du lithium dans la structure cristalline des composés d'intercalation contenus dans l'électrode active. Cette faible résistance interne du système traduit la facilité qu'ont les ions lithium à être intercalés ou désintercalés dans la structure cristalline du matériau actif.

Un exemple d'un procédé de fabrication du dispositif de mémoire précédemment décrit, va à présent être donné. On réalise tout d'abord la première couche 102 de la première électrode active. Le matériau actif de cette première couche 102 peut être du $LiMn_2O_4$ formé à partir d'une poudre de granulométrie contrôlée dont les dimensions sont de l'ordre du micron ou de la dizaine de microns. Cette poudre peut être ensuite frittée et utilisée comme cible dans un dispositif de dépôt physique en phase vapeur (ou PVD pour « *Physical Vapour Deposition* »). La première couche 102 peut être déposée sur une couche 108 conductrice électronique qui peut être à base d'un matériau métallique par exemple tel que du nickel. La couche 108 conductrice électronique est destinée à former le collecteur de courant de la première électrode. Selon une variante, on peut former la première couche 102 selon des procédés usuellement utilisés pour la réalisation d'électrodes d'accumulateurs au lithium (Journal of Power Sources, 1993, 44(1-3) : 689-700). Ensuite, on forme une couche 106 d'électrolyte sur la première couche 102 active. La couche d'électrolyte peut être réalisée par dépôt physique en phase vapeur d'un matériau conducteur ionique et isolant électronique, par exemple un verre de type « Lipon® » ou de composition : $1B_2O_3\text{-}0,8Li_2O\text{-}0,8Li_2SO_4$.

La deuxième couche active 104 de la deuxième électrode est ensuite déposée sur la couche d'électrolyte 106, en utilisant par exemple le même procédé de dépôt que pour la première couche 102 active de la première électrode. On réalise ensuite le dépôt d'une couche 110 conductrice électronique, par exemple par un dépôt de type dépôt physique en phase vapeur par exemple à base de nickel, destinée à former un deuxième collecteur de courant pour la deuxième électrode.

Ensuite, une encapsulation de l'ensemble peut être réalisée afin d'assurer la protection du dispositif. Le type d'encapsulation peut être choisi parmi les nombreux dispositifs utilisés en microélectronique, par exemple un enrobage dans une résine, ou tout autre dispositif évitant au système de risquer une contamination par l'environnement (poussières,...). Il est à noter que le dispositif selon l'invention n'a pas besoin d'être étanche à l'air dans la mesure où les matériaux actifs d'électrode sont stables à l'oxygène.

Les matériaux utilisés pour mettre en oeuvre un dispositif de mémoire suivant l'invention et tel que décrit précédemment, ne sont pas toxiques, ne nécessitent pas de précaution de manipulation particulière, sont peu coûteux et peuvent être manipulés en atmosphère ambiante ; ils s'adaptent aux techniques de réalisation en couches minces utilisées en microélectronique.

Le dispositif de mémoire électrochimique suivant l'invention présente une faible consommation, une sensibilité et une rapidité importantes, une bonne stabilité des électrodes dans le temps. Une cellule mémoire suivant l'invention présente une bonne réversibilité, le passage d'un état « ON » à un état « OFF » et d'un état « OFF » à un état « ON » pouvant être provoqué respectivement à l'aide d'une première impulsion de courant et d'une deuxième impulsion de courant opposée à la première impulsion ou d'une mise en court-circuit du système.

Un dispositif suivant l'invention met en oeuvre une mesure plus précise qu'un système suivant l'art antérieur fondé sur les variations de conductivité électrique de l'électrode, la mesure de conductivité d'une électrode étant une mesure moyenne.

Des électrodes d'épaisseur importante ne sont pas obligatoirement nécessaires, ces dernières pouvant avoir une épaisseur inférieure à 1 $\mu$m.

Le dispositif suivant l'invention n'est pas non plus limité à des électrodes à base de $LiMn_2O_4$ et peut être mis en oeuvre à l'aide d'autre matériaux cristallins conducteurs ionique et électronique, apte à libérer et/ou accepter au moins une espèce ionique et susceptibles de présenter une variation de potentiel électrochimique importante sous l'effet d'une faible variation de leurs compositions respectives.

Différents exemples de composés ou mélanges de composés, susceptibles de présenter une variation de potentiel supérieure ou égale à 0,3 volts ou à 0,5 volts pour une variation en concentration de l'espèce ionique inférieure à 5 % ou à 10 %, peuvent être utilisés. Le choix de tels matériaux peut être fait fonction de leur potentiel d'insertion/extraction du lithium. Le potentiel d'insertion/désinsertion du lithium dans les composés à base de métaux de transition dépend en particulier des couples de métaux $M^{n+1+}/M^{n+}$ considérés, des anions composants leur environnement proche (oxygène, soufre, sélénium ou polyanions à base de Si, P, S, Ge, As...),

Les électrodes peuvent être selon d'autres exemples :

- à base d'un composé de type spinelle tel que le $LiNi_{0.5}Mn_{1.5}O_4$ présentant deux processus d'intercalation/désintercalation bien distincts en potentiel : $\square Mn_2O_4(\lambda\text{-}MnO_2) \Leftrightarrow LiMn_2O_4 \Leftrightarrow Li_2Mn_2O_4$
- à base d'un composé de type olivine tel que le $LiMPO_4$, le $LiMSiO_4$, ou le $Li_xFe_{1-x}Mn_xPO_4$ présentant deux processus d'intercalation/désintercalation bien distincts en potentiel :

     o $\square Fe_{1-x}Mn_xPO_4 \Leftrightarrow Li_xFe_{1-x}Mn_xPO_4 \Leftrightarrow LiFe_{1-x}Mn_xPO_4$ (0<x<1)
     Etape 1 : 4.1V/Li$^+$/Li ; Etape 2 : 3.45V/Li$^+$/Li
     o $\square Fe_{1-x}CO_xPO_4 \Leftrightarrow Li_xFe_{1-x}Co_xPO_4 \Leftrightarrow LiFe_{i-x}Co_xPO_4$ (0<x<1).

Le choix de tels matériau peut être effectué à l'aide d'une évaluation *ab-initio* des potentiels d'intercalation par le calcul de d'énergie libre de Gibbs par des méthodes appliquant la théorie de la fonctionnelle de densité (DFT) avec différentes variantes.

Les électrodes peuvent être à base d'un mélange de deux composés dont les valeurs respectives de potentiel d'intercalation/désintercalation du lithium sont nettement différentes et qui comprend initialement un composé sous sa forme réduite et l'autre sous sa forme oxydée.

Selon une variante, les électrodes peuvent être à base de composés intercalant/désintercalant le lithium suivant un processus biphasé. De tels composés permettent d'avoir une rupture du profil de potentiel plus importante, et une distinction plus nette de part et d'autre de la composition initiale, afin d'obtenir une meilleur distinction entre les états de la mémoire. Des exemples de tels composés, susceptibles de servir de matériau d'électrode, sont donnés ci-dessous :

- o $\alpha \cdot \square FePO_4 + 1 - \alpha \cdot LiTiCrO_4 \Leftrightarrow \alpha \cdot LiFePO_4 + 1 - \alpha \cdot LiTiCrO_4 \Leftrightarrow \alpha \cdot LiFePO_4 + 1 - \alpha \cdot Li_2TiCrO_4$
- o $\alpha \cdot \square FePO_4 + 1 - \alpha \cdot Li_{4/3}Ti_{5/3}O_4 \Leftrightarrow \alpha \cdot LiFePO_4 + 1 - \alpha \cdot Li_{4/3}Ti_{5/3}O_4 \Leftrightarrow \alpha \cdot LiFePO_4 + 1 - \alpha \cdot Li_{7/3}Ti_{5/3}O_4$
- o $\alpha \cdot \square VPO_4F + 1 - \alpha \cdot Li_{4/3}Ti_{5/3}O_4 \Leftrightarrow \alpha \cdot LiVPO_4F + 1 - \alpha \cdot Li_{4/3}Ti_{5/3}O_4 \Leftrightarrow \alpha \cdot LiVPO_4F + 1 - \alpha \cdot Li_{7/3}Ti_{5/3}O_4$
- o $\alpha \cdot \square VPO_4F + 1 - \alpha \cdot Fe_2(MoO_4)_3 \Leftrightarrow \alpha \cdot LiVPO_4F + 1 - \alpha \cdot Fe_2(MoO_4)_3 \Leftrightarrow \alpha \cdot LiVPO_4F + 1 - \alpha \cdot Li_2Fe_2(MoO_4)_3$
- o $\alpha \cdot \square Ni_{0.5}Mn_{1.5}O_4 + 1 - \alpha \cdot \varepsilon VOPO_4 \Leftrightarrow \alpha \cdot LiNi_{0.5}Mn_{1.5}O_4 + 1 - \alpha \cdot \varepsilon VOPO_4 \Leftrightarrow \alpha \cdot LiNi_{0.5}Mn_{1.5}O_4 + 1 - \alpha \cdot LiVOPO_4$

## Revendications

1. Dispositif de mémoire (100) comprenant un empilement de couches comportant :

   - au moins une première couche active (102) à base d'un matériau cristallin conducteur ionique et électronique, apte à libérer et/ou accepter au moins une espèce ionique,
   - au moins une deuxième couche active (104) à base d'un matériau, cristallin conducteur ionique et électronique, apte à libérer et/ou accepter ladite espèce ionique,
   - au moins une couche formant un électrolyte (106) entre la première couche active et la deuxième couche active, et à base d'au moins un matériau conducteur ionique et isolant électronique, **caractérisé en ce que** :
   - la première couche et la deuxième couche actives (102, 104) sont à base de $LiMn_2O_4$ et présentent une variation de potentiel supérieure ou égale à 0,3 volts ou à 0,5 volts pour une variation en concentration de ladite espèce ionique inférieure à 5 % ou à 10 %,
   - et le dispositif comporte en outre des moyens de mesure (114) de la différence de potentiel électro-chimique entre ladite première couche active et de ladite deuxième couche active.

2. Dispositif de mémoire selon la revendication 1, comprenant en outre des moyens générateurs (112) de courant aptes à injecter du courant dans ledit empilement sous forme d'impulsions de courant.

3. Dispositif de mémoire selon la revendication 1 ou 2, comprenant en outre, au moins une couche (108) métallique en contact avec la première couche active (102) et/ou au moins une autre couche (110) métallique en contact avec la deuxième couche active (104).

4. Dispositif de mémoire selon l'une des revendications 1 à 3, la première couche active (102) et/ou la deuxième couche active (104) étant à base d'un composé d'intercalation comportant au moins un oxyde de métal de transition.

5. Dispositif de mémoire selon l'une des revendications 1 à 4, la première couche active (102) et la deuxième couche active (104) étant identiques.

6. Dispositif de mémoire selon l'une des revendications 1 à 5, la première couche active (102) et la deuxième couche active (104) étant à base de $LiMn_2O_4$.

7. Procédé de commande d'un dispositif de mémoire comprenant un empilement de couches comportant :

   - au moins une première couche active (102) à base d'un matériau cristallin conducteur ionique et électronique, apte à libérer et/ou accepter au moins une espèce ionique,
   - au moins une deuxième couche active (104) à base d'un matériau, cristallin conducteur ionique et électronique, apte à libérer et/ou accepter ladite espèce ionique,
   la première couche et la deuxième couche actives (102, 104) étant à base de $LiMn_2O_4$ et présentent une variation de potentiel supérieure ou égale à 0,3 volts ou à 0,5 volts pour une variation en concentration de ladite espèce ionique inférieure à 5 % ou à 10 %,
- au moins une couche formant un électrolyte (106) entre la première couche active et la deuxième couche active, et à base d'au moins un matériau conducteur ionique et isolant électronique,
le procédé comprenant au moins une étape de mesure (114) de la différence de potentiel électrochimique entre ladite première couche active et de ladite deuxième couche active.

8. Procédé selon la revendication 7, comprenant au moins une étape d'injection d'au moins une impulsion de courant dans ledit empilement.

**Claims**

1. Memory device (100) comprising a stack of layers including:

    - at least one first active layer (102) based on a crystalline ionic and electronic conducting material capable of releasing and/or accepting at least one ionic species;
    - at least one second active layer (104) based on a crystalline ionic and electronic conducting material capable of releasing and/or accepting said ionic species;
    - at least one layer forming an electrolyte (106) between the first active layer and the second active layer, and based on at least one ionic conducting and electronic insulating material, **characterized in that**:

        the first active layer and the second active layer (102, 104) are based on $LiMn_2O_4$ and can have a potential variation higher than or equal to 0.3 volts or 0.5 volts for a variation in the concentration of said ionic species of less than 5% or 10%,

    - measurement means for measuring the electrochemical potential difference between said first active layer and said second active layer.

2. Memory device according to claim 1, comprising generating means (112) capable of injecting current into said stack in the form of current pulses.

3. Memory device according to claim 1 or 2, also comprising at least one metallic layer (108) in contact with the first active layer (102) and/or at least one other metallic layer (110) in contact with the second active layer (104).

4. Memory device according to one of claims 1 or 2, the first active layer (102) and/or the second active layer (104) being based on an intercalation compound comprising at least one transition metal oxide.

5. Memory device according to one of claims 1 to 4, the first active layer (102) and the second active layer (104) being identical.

6. Memory device according to one of claims 1 to 5, the first active layer and the second active layer being based on $LiMn_2O_4$.

7. Process for control of a memory device containing a stack of layers comprising:

    - at least one first active layer (102) based on a crystalline ionic and electronic conducting material capable of releasing and/or accepting at least one ionic species;
    - at least one second active layer (104) based on a crystalline ionic and electronic conducting material capable of releasing and/or accepting said ionic species;
    the first active layer and the second active layer (102, 104) being based on $LiMn_2O_4$ and can have a potential variation higher than or equal to 0.3 volts or 0.5 volts for a variation in the concentration of said ionic species of less than 5% or 10%;
    - at least one layer forming an electrolyte (106) between the first active layer and the second active layer, and based on at least one ionic conducting and electronic insulating material;
    the method comprising at least one measurement step for measuring the electrochemical potential difference between said first active layer and said second active layer.

8. Method according to claim 7, comprising at least one injection step for injecting at least one current pulse into said stack.

## Patentansprüche

1.  Speichereinrichtung (100), umfassend einen Stapel von Schichten, umfassend:

    - wenigstens eine erste aktive Schicht (102) auf Grundlage eines kristallinen, Ionen- und Elektronen-leitenden Materials, welches dazu geeignet ist, wenigstens eine Ionenart freizusetzen oder/und aufzunehmen,
    - wenigstens eine zweite aktive Schicht (104) auf Grundlage eines kristallinen, Ionen- und Elektronen-leitenden Materials, welches dazu in der Lage ist, die Ionenart freizusetzen oder/und aufzunehmen,
    - wenigstens eine Schicht, welche einen Elektrolyten (106) zwischen der ersten aktiven Schicht und der zweiten aktiven Schicht bildet, und auf wenigstens einem Ionen-leitenden und für Elektronen isolierenden Material basiert,

    **dadurch gekennzeichnet, dass**:

    - die erste aktive Schicht und die zweite aktive Schicht (102, 104) auf $LiMn_2O_4$ basieren und eine Potenzial-Variation von größer oder gleich 0,3 V oder 0,5 V für eine Variation in der Konzentration der Ionenart von kleiner als 5 % oder 10 % aufweisen,
    - und die Einrichtung weiterhin Messmittel (114) für die elektrochemische Potenzialdifferenz zwischen der ersten aktiven Schicht und der zweiten aktiven Schicht umfasst.

2.  Speichereinrichtung nach Anspruch 1, umfassend weiterhin Stromerzeugungsmittel (112), die geeignet sind, Strom in den Stapel in der Form von Strompulsen zu injizieren.

3.  Speichereinrichtung nach Anspruch 1 oder 2, weiterhin umfassend wenigstens eine metallische Schicht (108) in Kontakt mit der ersten aktiven Schicht (102) oder/und wenigstens eine andere metallische Schicht (110) in Kontakt mit der zweiten aktiven Schicht (104).

4.  Speichereinrichtung nach einem der Ansprüche 1 bis 3, wobei die erste aktive Schicht (102) oder/und die zweite aktive Schicht (104) auf einer Interkalationsverbindung basieren, welche wenigstens ein Übergangsmetalloxid umfasst.

5.  Speichereinrichtung nach einem der Ansprüche 1 bis 4, wobei die erste aktive Schicht (102) und die zweite aktive Schicht (104) identisch sind.

6.  Speichereinrichtung nach einem der Ansprüche 1 bis 5, wobei die erste aktive Schicht (102) und die zweite aktive Schicht (104) auf $LiMn_2O_4$ basieren.

7.  Verfahren zur Steuerung/Regelung einer Speichereinrichtung, welche einen Stapel von Schichten umfasst, umfassend:

    - wenigstens eine erste aktive Schicht (102) auf Basis eines kristallinen, Ionen- und Elektronen-leitenden Materials, das dazu geeignet ist, wenigstens eine Ionenart freizusetzen oder/und aufzunehmen,
    - wenigstens eine zweite aktive Schicht (104) auf Basis eines kristallinen, Ionen- und Elektronen-leitenden Materials, das dazu geeignet ist, die Ionenart aufzunehmen oder/und freizusetzen, wobei die erste aktive Schicht und die zweite aktive Schicht (102, 104) auf $LiMn_2O_4$ basieren und eine Potenzialvariation von größer oder gleich 0,3 V oder 0,5 V für eine Konzentrationsvariation der Ionenart von kleiner 5 % oder 10 % aufweisen,
    - wenigstens eine Schicht, welche einen Elektrolyten (106) zwischen der ersten aktiven Schicht und der zweiten aktiven Schicht bildet und auf wenigstens einem Ionen-leitenden und für Elektronen isolierenden Material basiert, wobei das Verfahren wenigstens einen Messschritt (114) der elektrochemischen Potenzialdifferenz zwischen der ersten aktiven Schicht und der zweiten aktiven Schicht umfasst.

8.  Verfahren nach Anspruch 7, umfassend wenigstens einen Schritt einer Injektion von wenigstens einem Strompuls in den Stapel.

# FIG. 1

# FIG. 2

**RÉFÉRENCES CITÉES DANS LA DESCRIPTION**

**Documents brevets cités dans la description**

- US 5761115 A
- US 6864522 B
- EP 1571673 A
- EP 380058 A

**Littérature non-brevet citée dans la description**

- *Journal of Power Sources,* 1993, vol. 44 (1-3), 689-700